# EUROPEAN PATENT SPECIFICATION

(11) **EP 0 447 989 B1**
(45) Date of publication and mention of the grant of the patent: **09.08.1995**
(21) Application number: 91104045.9
(22) Date of filing: 15.03.1991
(51) Int. Cl.: H02M 1/08, H03K 17/04

(54) **High speed driving circuit for MOSFET transistors**
Treiberschaltung hoher Geschwindigkeit für MOSFET-Transistoren
Circuit de commande à haute vitesse pour des transistors MOSFET

(30) Priority: 19.03.1990 IT 8253990
(43) Date of publication of application: 25.09.1991
(73) Proprietor: SEIT ELETTRONICA S.R.L., I-31049 Valdobbiadene (Treviso) (IT)
(72) Inventor: Corticelli, Giuliano, I-35100 Padova (IT)
(74) Representative: Modiano, Guido, Dr.-Ing.

(56) References cited:
- EP-A- 0 177 148
- EP-A- 0 294 887
- EPE 3RD EUROPEAN CONFERENCE ON POWER ELECTRONICS AND APLLICATIONS, 9-12 October 1989, Aachen, DE, pp. 165-169 ; H.C. Lovatt et al. : "Design of a 3-phase, MOSFET inverter and associated gate-drive circuit"

## Description

The present invention relates to a high speed driving circuit for MOSFET transistors.

The invention relates to the entire range of electronic circuits commonly termed "switching power supplies", with particular reference to the conceptual layouts which use electronic switches the drivers whereof are not connected to the same voltage.

In this field, the most common and known types included in these layouts are those usually called "half-bridge", "asymmetrical half-bridge" and "full-bridge".

These indicated configurations are, among known ones, those which allow to reach the highest power values.

However, these known circuits have some disadvantages, which are essentially due to difficulty in correctly driving the electronic switches, which are actually provided by means of active electronic components (bipolar transistors, SCRs, MOSFET transistors).

Thus, if MOSFET transistors are used in the half-bridge and full-bridge circuit, by using N-channel transistors with respect to P-channel ones, the former being markedly privileged in semiconductor technology, the problem of adequately driving these MOSFET transistors and in particular the one connected to V_{cc} (or power supply) is rather complex.

For this purpose, some solutions are already known; one is known as "level shifter" and uses a low-power transistor which is connected to the negative voltage and can withstand the entire power supply; this transistor drives, more or less directly, the MOS power transistor; however, disadvantages are still observed, since optimization is not easy and the choice of the component is rather troublesome if V_{cc} (the direct power supply) is high (300 or 500 Volts, as often occurs when rectifying 220 Volts AC or three-phase 380 Volts).

Another known solution which has already been adopted is that of so-called high speed photocouplers; although it has some advantages, this solution requires a floating power supply connected to the source pin of the final power stage.

Propagation delays for more easily available devices (commercially indicated by the code 6N 137 of Company HP) are not negligible at high frequencies such as those which can be reached by MOSFET transistors.

Common-mode noise rejection (1000/2000 V/»sec) can also be insufficient with these devices and with high voltages.

Another solution which has already been adopted is to use the new integrated circuits by I.R.; this solution, which is very recent, is satisfactory from some points of view but also has disadvantages, since the devices used do not operate at high voltages and the current available for driving is rather limited.

Another solution which has already been adopted consists in using coupling transformers: this, too, is a solution which is satisfactory from some points of view, but even in this case some disadvantages can be observed: if special precautions are not taken, the inductance dispersed between the two multiturn coils, even if they are well-coupled, limits the rise rate of the drive, especially if the MOSFET transistor has considerable intrinsic capacitances, as in the case of high-current and high-voltage voltage MOSFET transistors.

This dispersed inductance, which thus occurs "in series", can furthermore resonate with input capacitances ("in parallel"), causing spurious over-oscillations which are dangerous for the MOSFET transistor (20 V between gate pin and source pin are already critical), and this requires clipping and damping circuits which invalidate the advantage of simplicity and reduce driving quality.

With this solution it is furthermore virtually impossible to transmit drive signals with a highly variable duty cycle as in the case of PWM signals.

With some provisions, it is instead possible to pass through the transformers signals with a duty cycle comprised between 0 and 50%, as in the case of many circuits of switching power supplies.

As a partial solution to these disadvantages, the inventor of the present application has filed, on April 13, 1989, Italian Patent Application no. 41571 A/89, related to a driving circuit for power MOSFET transistors which has a low cost and is extremely fast and which, despite solving most of the above disadvantages, was not optimum if a power of 2 KW at the frequency of 2.5 MHz was to be handled.

At such values, the frequency involved is five times higher than that used in the circuit according to application no. 41571 A/89, and this leads to a drastic increase in the power required to drive the power switches, since they must be switched on and off as fast as possible in a total time of approximately 400 nanoseconds, which is the period which corresponds to 2.5 MHz. A high speed driving circuit for MOSFET transistors including the features of the preamble of claim 1 is known from EP-A-177 148.

The aim of the present invention is therefore to eliminate the disadvantages described above in known types by providing a high speed driving circuit for MOSFET transistors which allows to provide a full-bridge device which operates at 2.5 MHz and is capable of handling a power of up to approximately 2.4 KW.

Within the scope of the above aim, an important object is to provide a circuit which is structurally simple and can be manufactured with known facilities and machinery.

Not least object is to provide a circuit which is reliable and safe in use.

This aim, these objects and others which will become apparent hereinafter are achieved by a high speed driving circuit for MOSFET transistors, as defined in claim 1.

Further characteristics and advantages of the invention will become apparent from the detailed description of a particular but not exclusive embodiment, illustrated only by way of non-limitative example in the accompanying drawings, wherein:

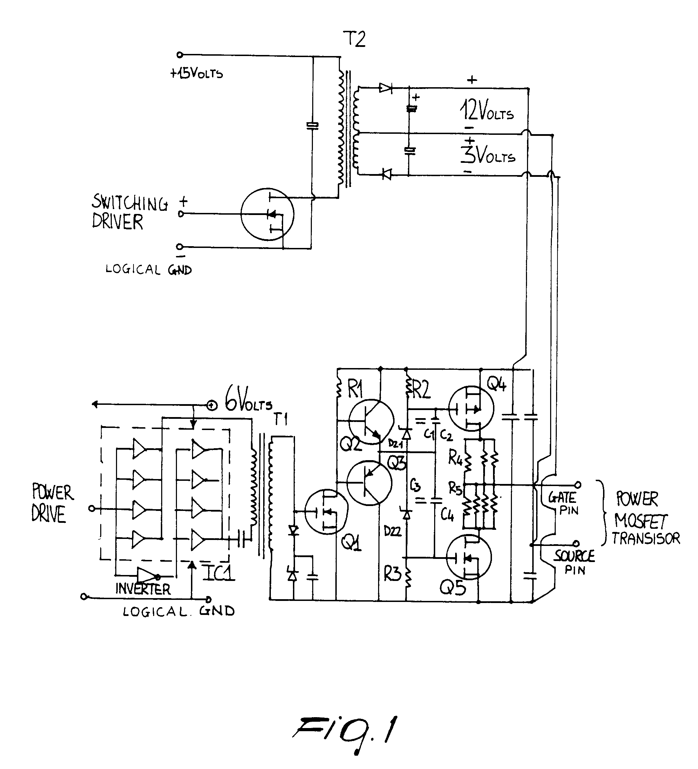

figure 1 is a circuit layout of the high speed driving circuit for MOSFET transistors according to the invention.

With reference to the above figure, the reference sign T1 indicates a first coupling transformer, which is driven on the drive logic side IC1, has a turns ratio equal to 2:1 and is wound with such a method as to have minimal dispersed reactance, although it has a very high immunity to dV/dt, which in this application reaches 10 KV/»sec.

The circuit furthermore comprises a first stage of the actual driver, indicated by Q1, which is constituted by a small MOSFET transistor with an IDmax of a few hundred mA.

The first stage Q1 is the most suitable for using the signal which is present on the secondary coil of the first transformer T1 without at the same time excessively loading the logic IC1 and the primary coil.

The first stage Q1 is furthermore suitable for driving the subsequent second stage, indicated by Q2 and Q3, with rather steep fronts.

The second stage Q2 and Q3, which is directly coupled to the drain pin of the first stage Q1, is constituted by a pair of medium-power bipolar transistors, for example of the type commercially known by the code BD 137 - BD 138; the pair of medium-power bipolar transistors Q2 and Q3 must be suitable for providing a current with an amplitude sufficient to directly drive two MOSFET transistors of a third stage of the driver which are indicated by Q4 and Q5.

The third stage of the driver is constituted by two medium-power complementary MOSFET transistors Q4 and Q5, with auxiliary circuitry, indicated in the drawing, which is included essentially in order to reduce the dissipation of the two MOSFET transistors Q4 and Q5, limiting simultaneous conduction and in any case decreasing the "transverse" current, and to drive the final MOSFET transistor according to two distinct paths, thus allowing to easily and independently vary the on and off switching speeds.

In resonant converters, for example, it is in fact convenient to switch the final MOSFET transistors off very rapidly, whereas switching on can be much slower.

The driving circuit furthermore has a driver power supply with two voltages, at +12 V and at -3 V with respect to the source pin of the final stage; this has been found to be the best compromise between the need to powerfully drive the final stages, making them immune with respect to oscillations on the gate pin circuit, and containing the dissipation on the two MOSFET transistors Q4 and Q5 of the third stage.

The power supplies are provided by means of a second ferrite transformer, indicated by the T2, which operates at 100 KHz; the transformer T2 is built so as to have good insulation and a rather low capacitance between the primary and secondary multiturn coils without penalizing it excessively with a high dispersed reactance.

It has thus been observed that the invention has achieved the intended aim and objects, a high speed driving circuit for MOSFET transistors having been obtained which, by virtue of the use of four drivers, driven by an adequate control logic IC1, and with four final MOSFET transistors with adequate characteristics, has allowed to provide a full-bridge circuit which operates at 2.5 MHz and can handle power up to approximately 2.4 KW.

The invention is naturally susceptible to numerous modifications and variations, all of which are within the scope of the claims.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. High speed driving circuit for MOSFET transistors comprising:
a first coupling transformer (T1) which is driven at its primary coil and has a turns ratio of 2:1, said turns being wound such that said first coupling transformer has a minimal reactance and very high immunity to dV/dt; and
a first stage (Q1);
characterized in that said driving circuit further comprises a second stage (Q2,Q3) and a third stage (Q4,Q5),
said first stage (Q1) being constituted by a small MOSFET transistor, said first stage (Q1) being adapted for using a signal which is present on the second coil of said first coupling transformer (T1) for driving a second stage (Q2,Q3) without at the same time excessively loading the primary coil of said first coupling transformer (T1);
said second stage (Q2,Q3) being directly coupled to the drain terminal of said first stage (Q1), such as to be driven by said first stage (Q1), said second stage (Q2,Q3) being adapted to provide for a current with an amplitude sufficient to directly drive said third stage (Q4,Q5);
said third stage (Q4,Q5) for driving a final MOSFET transistor, said third stage (Q4,Q5) being supplied with two distinct voltages, said two distinct voltages being provided by a second transformer (T2).

2. Circuit according to claim 1, characterized in that said first coupling transformer (T1) is driven at its primary coil by means of two HC-MOS quadruple buffers (IC1) in full-bridge connection.

3. Circuit according to claims 1 and 2, characterized in that said dV/dt reaches values which are approximately equal to 10 KV/»sec.

4. Circuit according to one or more of claims 1-3, characterized in that said small MOSFET transistor of said first stage (Q1) has an IDmax value of a few hundred mA, said small MOSFET transistor using the signal which is present on the secondary coil of said first coupling transformer (T1).

5. Circuit according to claims one or more of claims 1-4, characterized in that said second stage (Q2,Q3) is constituted by a pair of medium-power bipolar transistors (Q2,Q3).

6. Circuit according to one or more of claims 1-5, characterized in that said third stage is comprised of two complementary medium-power MOSFET transistors (Q4,Q5) which are connected to an auxiliary circuitry (R1,R2,R3,R4, R5,D21,D22,C1,C2,C3,C4) which is adapted to reduce dissipation, to reduce a transverse current between said complementary medium-power MOSFET transistors (Q4,Q5) and to drive a final MOSFET transistor according to two distinct paths in order to independently and easily vary the switching speed during switching on and switching off.

7. Circuit according to one or more of claims 1-6, characterized in that said drive circuit can be supplied with voltages at +12 V and -3 V with respect to the source pin of said final MOSFET transistor.

8. Circuit according to one or more of claims 1-7, characterized in that said second transformer (T2) is made of ferrite, preferably operates at 100 KHz, has good insulation, a reduced capacitance between the primary and secondary coils, and a modest dispersed reactance.

9. Circuit according to one or more of the preceding claims, characterized in that said auxiliary circuitry is comprised of a plurality of resistors (R1,R2,R3,R4, R5), capacitors (C1,C2,C3,C4) and diodes (D21,D22).

## Patentansprüche

1. Hochgeschwindigkeits-Treiberschaltung für MOSFET-Transistoren, enthaltend:
einen ersten Koppeltransformator (T1), der an seiner Primärwicklung angesteuert wird und ein Wicklungsverhältnis von 2:1 aufweist, wobei die Wicklungen derart gewickelt sind, daß der erste Koppeltransformator eine minimale Reaktanz und eine geringe Empfindlichkeit gegenüber dV/dt aufweist, und eine erste Stufe (Q1),
dadurch **gekennzeichnet**, daß die Treiberstufe ferner eine zweite Stufe (Q2, Q3) und eine dritte Sufte (Q4, Q5) enthält, wobei
die erste Stufe (Q1) durch einen kleinen MOSFET-Transistor gebildet ist, wobei die erste Stufe (Q1) derart ausgebildet ist, daß sie ein an der Sekundärseite des ersten Koppeltransformators (T1) vorliegendes Signal zum Treiben einer zweiten Stufe (Q2, Q3), ohne gleichzeitig die Primärwicklung des ersten Koppeltransformators (C1) übermäßig zu belasten,
die zweite Stufe (Q2, Q3) dirent an den Drain-Anschluß der ersten Stufe (Q1) derart angeschlossen ist, daß sie durch die erste Stufe (Q1) getrieben wird, wobei die zweite Stufe (Q2, Q3) so ausgebildet ist, daß sie einen Strom mit ausreichender Amplitude zum direkten Treiben der dritten Stufe (Q4, Q5) liefert,
die dritte Stufe (Q4, Q5) zum Treiben eines Anschluß-MOSFET-Transistors enthalten ist, wobei die dritte Stufe (Q4, Q5) mit zwei unterschiedlichen Spannungen versorgt wird, wobei die beiden unterschiedlichen Spannungen durch einen zweiten Transformator (T2) gebildet werden.

2. Schaltung nach Anspruch 1, dadurch gekennzeichnet, daß der erste Koppeltransformator (T1) an seiner Primärwicklung durch zwei HC-MOS-Quadraturpuffer (IC1) in Vollbrücken-Verbindung getrieben wird.

3. Schaltung nach Anspruch 1 oder 2, dadurch gekennzeichnet, daß dV/dt einen Wert von ungefähr gleich 10 KV/»sek erreicht.

4. Schaltung nach einem der Ansprüche 1 bis 3, dadurch gekennzeichnet, daß der kleine MOSFET-Transistor der ersten Stufe (QD) einen IDmax-Wert von einigen hundert Milliampere aufweist, wobei der kleine MOSFET-Transistor das an der Sekundärwicklung des ersten Koppeltransformators (T1) anliegende Signal benützt.

5. Schaltung nach einem der Ansprüche 1 bis 4, dadurch gekennzeichnet, daß die zweite Stufe (Q2, Q3) durch ein Paar von Bipolartransistoren (Q2, Q3) im mittleren Leistungsbereich gebildet wird.

6. Schaltung nach einem der Ansprüche 1 bis 5, dadurch gekennzeichnet, daß die dritte Stufe mit zwei komplementären MOSFET-Transistoren (Q4, Q5) mittlerer Leistung gebildet ist, die an eine Hilfsschaltung (R1, R2, R3, R4, R5, D21, D22, C1, C2, C3, C4) angeschlossen sind, die gebildet ist, um die Dissipation und einen Querstrom zwischen den komplementären MOSFET-Transistoren (Q4, Q5) mittlerer Leistung herabzusetzen und um einen Abschluß-MOSFET-Transistor über zwei unterschiedliche Pfade zu treiben, um in unabhängiger und einfacher Weise die Schaltgeschwindigkeit während des An- und Abschaltens zu verändern.

7. Schaltung nach einem der Ansprüche 1 bis 6, dadurch gekennzeichnet, daß die Treiberschaltung mit Spannungen von 12V und -3V im Hinblick auf den Source-Anschluß des Abschluß-MOSFET-Transistors versorgt werden kann.

8. Schaltung nach einem der Ansprüche 1 bis 7, dadurch gekennzeichnet, daß der zweite Transformator (T2) aus Ferrit besteht, vorzugsweise bei 100 KHz betrieben wird, eine gute Isolation, eine herabgesetzte Kapazität zwischen der Primär- und Sekundärwicklung, und eine geringe Streureaktanz aufweist.

9. Schaltung nach einem oder mehreren der vorhergehenden Ansprüche, dadurch gekennzeichnet, daß die Hilfsschaltung aus einer Vielzahl von Widerständen (R1, R2, R3, R4, R5), Kapazitäten (C1, C2, C3, C4) und Dioden (D21, D22) gebildet ist.

## Revendications

1. Circuit de commande à haute vitesse pour des transistors MOSFET, comprenant :
un premier transformateur de couplage (T1) qui est attaqué à son enroulement primaire et possède un rapport de transformation de tours de 2:1, lesdits tours étant bobinés de telle manière que ledit premier transformateur de couplage ait une réactance minimale et une très haute immunité au dV/dt ; et
un premier étage (Q1) ;
caractérisé en ce que ledit circuit de commande comprend en outre un deuxième étage (Q2, Q3) et un troisième étage (Q4, Q5),
ledit premier étage (Q1) étant constitué par un petit transistor MOSFET, ledit premier étage (Q1) étant adapté pour utiliser un signal qui est présent sur le deuxième enroulement dudit premier transformateur de couplage (T1) pour attaquer un deuxième étage (Q2, Q3) sans en même temps charger excessivement le premier enroulement dudit premier transformateur de couplage (T1) ;
ledit deuxième étage (Q2, Q3) étant couplé directement à la borne de drain dudit premier étage (Q1) de manière à être attaqué par ledit premier étage (Q1), ledit deuxième étage (Q2, Q3) étant adapté pour fournir un courant d'une amplitude suffisante pour attaquer directement ledit troisième étage (Q4, Q5) ;
ledit troisième étage (Q4, Q5) servant à attaquer un transistor MOSFET final, ledit troisième étage (Q4, Q5) étant alimenté avec deux tensions distinctes, lesdites deux tensions distinctes étant fournies par un deuxième transformateur (T2).

2. Circuit selon la revendication 1, caractérisé en ce que ledit premier transformateur de couplage (T1) est attaqué à son enroulement primaire au moyen de deux amplificateurs-séparateurs HC-MOS (IC1) connectés en pont complet.

3. Circuit selon les revendications 1 et 2, caractérisé en ce que ledit dV/dt atteint des valeurs qui sont approximativement égales à 10 kV/»s.

4. Circuit selon une ou plusieurs des revendications 1 à 3, caractérisé en ce que ledit petit transistor MOSFET dudit premier étage (Q1) a une valeur IDmax de quelques centaines de mA, ledit petit transistor MOSFET utilisant le signal qui est présent sur l'enroulement secondaire dudit premier transformateur de couplage (T1).

5. Circuit selon une ou plusieurs des revendications 1 à 4, caractérisé en ce que ledit deuxième étage (Q2, Q3) est constitué par une paire de transistors bipolaires de moyenne puissance (Q2, Q3).

6. Circuit selon une ou plusieurs des revendications 1 à 5, caractérisé en ce qui ledit troisième étage comprend deux transistors MOSFET complémentaires de moyenne puissance (Q4, Q5) qui sont connectés à un circuit auxiliaire (R1, R2, R3, R4, R5, D21, D22, C1, C2, C3, C4) qui est adapté pour réduire la dissipation, pour réduire un courant transversal entre lesdits transistors MOSFET de moyenne puissance complémentaires (Q4, Q5) et pour attaquer un transistor MOSFET final selon deux trajets distincts pour permettre de faire varier indépendamment et facilement la vitesse de commutation pendant une commutation en conduction et une commutation en blocage.

7. Circuit selon une ou plusieurs des revendications 1 à 6, caractérisé en ce que ledit circuit d'attaque peut être alimenté avec des tensions à +12 V et -3 V par rapport à la broche de source dudit transistor MOSFET final.

8. Circuit selon une ou plusieurs des revendications 1 à 7, caractérisé en ce que ledit deuxième transformateur (T2) est fait de ferrite, fonctionne de préférence à 100 kHz, a une bonne isolation, une capacitance réduite entre les enroulements primaire et secondaire et une réactance répartie modérée.

9. Circuit selon une ou plusieurs des revendications précédentes, caractérisé en ce que ledit circuit auxiliaire comprend d'une pluralité de résistances (R1, R2, R3, R4, R5), de condensateurs (C1, C2, C3, C4) et de diodes (D21, D22).
